(19) Europäisches Patentamt
European Patent Office
Office européen des brevets

(11) EP 2 241 899 A1

(12) EUROPEAN PATENT APPLICATION
published in accordance with Art. 153(4) EPC

(43) Date of publication:
20.10.2010 Bulletin 2010/42

(51) Int Cl.:
$G01R\ 27/28^{(2006.01)}$     $G01R\ 35/00^{(2006.01)}$

(21) Application number: 08872059.4

(86) International application number:
PCT/JP2008/072236

(22) Date of filing: 08.12.2008

(87) International publication number:
WO 2009/098816 (13.08.2009 Gazette 2009/33)

(84) Designated Contracting States:
AT BE BG CH CY CZ DE DK EE ES FI FR GB GR
HR HU IE IS IT LI LT LU LV MC MT NL NO PL PT
RO SE SI SK TR
Designated Extension States:
AL BA MK RS

(30) Priority: 05.02.2008 JP 2008025778

(71) Applicant: Murata Manufacturing Co. Ltd.
Kyoto 617-8555 (JP)

(72) Inventor: MORI, Taichi
Nagaokakyo-shi
Kyoto 617-8555 (JP)

(74) Representative: Zimmermann, Tankred Klaus et al
Schoppe, Zimmermann, Stöckeler
Zinkler & Partner
P.O. Box 246
82043 Pullach (DE)

(54) **MEASUREMENT ERROR CORRECTING METHOD AND ELECTRONIC PART CHARACTERISTIC MEASURING INSTRUMENT**

(57)     Provided are a method for correcting measurement errors and an electronic component characteristics measurement device that can improve the correction precision by eliminating the correction errors caused by leakage signal components between the ports of the measurement jigs.

An equation $CA_{ij}$ that correlates measurement values in a test measurement jig mounted state with measurement values in a standard measurement jig mounted state is determined from a result of measuring electric characteristics $S_D$, $S_T$ on correction data obtaining samples having different electric characteristics with each other in a state in which they are mounted on a standard measurement jig 20 and on a test measurement jig 30. The equation $CA_{ij}$ is an equation that assumes presence of leakage signals that are directly transmitted between at least two ports of at least one of the standard measurement jig and the test measurement jig. By using the equation $CA_{ij}$ determined by measuring the electric characteristics on an arbitrary electronic component in a state in which it is mounted on the test measurement jig 30, the electric characteristics that would be obtained if measured on the electronic component in a state in which it is mounted on the standard measurement jig 20 are calculated.

Fig. 2

**Description**

TECHNICAL FIELD

The present invention relates to a method for correcting measurement errors and an electronic component characteristics measuring device. More particularly, the present invention relates to a method for correcting measurement errors and an electronic component characteristics measuring device that calculate an estimated value of electric characteristics that would be obtained if measured in a state in which an electronic component is mounted on a standard measurement jig from a result of measuring the electric characteristics in a state in which the electric component is mounted on a test measurement jig.

BACKGROUND ART

Conventionally, an electronic component that does not have a coaxial connector such as a surface-mounting type electronic component may be mounted on a measurement jig having a coaxial connector, and the measurement jig may be connected to a measuring device via a coaxial cable, so as to measure the electric characteristics. In such a measurement, variation in the characteristics among individual measurement jigs and variation in the characteristics among individual coaxial cables and measurement devices are a cause of measurement errors.

As to a coaxial cable and a measurement device, by connecting a standard device having standard characteristics to the measuring device via the coaxial cable for making measurements, the errors on the side closer to the measuring device than the tip end of the coaxial cable connected to the standard device can be identified.

However, as to a measurement jig, it is not possible to identify precisely the errors of electric characteristics between the connection terminal of the part on which the electronic component is mounted and the coaxial connector for connecting to the coaxial cable. Also, it is not easy to make adjustments so that the characteristics among the measurement jigs may be made equal to each other. In particular, it is extremely difficult to adjust the measurement jigs so that the characteristics among the measurement jigs may be made equal to each other in a large bandwidth.

Therefore, a so-called relative correction method is proposed in which correction data obtaining samples are mounted on a plurality of measurement jigs for making measurements, and an equation that corrects the relative errors between a certain measurement jig (hereinafter, referred to as a "standard measurement jig") and another measurement jig (hereinafter, referred to as a "test measurement jig") is deduced in advance from the variation in the measurement values among the measurement jigs, whereby, from a measurement value of electric characteristics of an arbitrary electronic component obtained in a state in which the electronic component is mounted on the test measurement jig, an estimated value of the measurement value that would be obtained if measured in a state in which the electronic component is mounted on the standard measurement jig is calculated by using this equation.

For example, the standard measurement jig is used for ensuring electric characteristics to users, and the test measurement jig is used for measurement for selecting good products in a step of manufacturing electronic components.

Specifically, for each port, a scattering matrix obtained by synthesizing a scattering matrix $S_T$ that removes test measurement jig errors with a scattering matrix of standard measurement jig errors (this is referred to as a "relative correction adaptor") is deduced. By synthesizing the relative correction adaptor with a scattering matrix of a test measurement jig measurement value, an estimated value of the standard measurement jig measurement value is calculated. The relative correction adaptor can be calculated from a result of measuring at least three one-port correction data obtaining samples (such as Open, Short, and Load) in both of the standard measurement jig and the test measurement jig for each port (see, for example, Patent Document 1, and Non-Patent Documents 1, 2).

Patent Document 1: Japanese Patent No. 3558074
Non-Patent Document 1: GAKU KAMITANI (Murata manufacturing Co., Ltd.) "A METHOD TO CORRECT DIFFERENCE OF IN-FIXTURE MEASUREMENTS AMONG FIXTURES ON RF DEVICES" APMC Vol.2, pp. 1094-1097, 2003
Non-Patent Document 2: J.P.DUNSMORE, L.BETTS (Agilent Technologies) "NEW METHODS FOR CORRELATING FIXTURED MEASUREMENTS" APMC Vol.1, pp. 568-571, 2003

DISCLOSURE OF THE INVENTION

Problems to be solved by the invention

However, the above-described relative correction adaptor does not treat leakage signal components that are directly transmitted between the ports of measurement jigs and are not transmitted to the electronic component connected between the ports as an object of correction. For this reason, correction errors will remain definitely by the leakage signal components that are present in a no small amount in the measurement jigs.

Such correction errors necessitate increase of the margin for determining good or bad in the selection step by the amount of the correction errors, thereby causing decrease in the yield ratio.

Moreover, according as the scale reduction of the electronic components proceeds hereafter, the distance between the ports will be smaller, and the leakage signal components of the measurement jigs for measuring the electronic components will be larger, whereby the correction errors also will inevitably increase. For this reason, it will not be possible to meet the need only by increasing the margin for determining good or bad, leading to a possibility such that the determination of good or bad itself cannot be carried out in the selection step.

In view of such circumstances, the present invention aims at providing a method for correcting measurement errors and an electronic component characteristics measurement device that can improve the correction precision by eliminating the correction errors caused by leakage signal components between the ports of the measurement jigs.

Means for solving the problems

In order to solve the aforementioned problems, the present invention provides a method of correcting measurement errors constructed in the following manner.

There is provided a method of correcting measurement errors by calculating, from a result of measuring electric characteristics in a state in which an electronic component having arbitrary n ports of two or more ports is mounted on a test measurement jig, an estimated value of the electric characteristics that would be obtained when measured in a state in which the electronic component is mounted on a standard measurement jig. The method of correcting measurement errors includes: (1) a first step of measuring the electric characteristics in a state in which at least three first correction data obtaining samples having different electric characteristics with each other are mounted on the standard measurement jig; (2) a second step of measuring electric characteristics in a state in which (a) the at least three first correction data obtaining samples, (b) at least three second correction data obtaining samples assumed to have electric characteristics equivalent to those of the at least three first correction data obtaining samples, or (c) at least one third correction data obtaining sample assumed to have electric characteristics equivalent to those of a part of the at least three first correction data obtaining samples and the other ones of the first correction data obtaining samples are mounted on the test measurement jig; (3) a third step of determining an equation that correlates, on one and the same electronic component, measurement values of electric characteristics measured in a state in which the electronic component is mounted on the test measurement jig with measurement values of electric characteristics measured in a state in which the electronic component is mounted on the standard measurement jig, from a result of measurements in the first and second steps, where the equation assumes presence of leakage signals that are directly transmitted between at least two ports of at least one of the standard measurement jig and the test measurement jig without being transmitted to the electronic component connected to the two ports; (4) a fourth step of measuring electric characteristics in a state in which an arbitrary electronic component is mounted on the test measurement jig; and (5) a fifth step of calculating electric characteristics that would be obtained when measured in a state in which the electronic component is mounted on the standard measurement jig, from a result of measurement in the fourth step by using the equation determined in the third step.

According to the above method, the electric characteristics are estimated by using the equation that assumes the leakage signals between the ports. Therefore, when relative correction is made by using a test measurement jig and a standard measurement jig in which leakage signals are present between the ports, the correction precision of measurement errors will be improved as compared with a case in which the electric characteristics are estimated by using an equation that does not assume leakage signals between the ports at all.

Here, in the first, second, and fourth steps, because it will be sufficient if the measurement system connected to the test measurement jig or the standard measurement jig for measuring the electric characteristics can be regarded as having identical characteristics, a physically different measurement system, for example, a different measuring device, connection cable, or the like, may be used.

Preferably, when all the ports at which the leakage signals are present are corrected in each of the base measurement jig and the test measurement jig, electric characteristics are measured in a state in which at least five of the first correction data obtaining samples having different electric characteristics with each other are mounted on the standard measurement jig in the first step.

In the second step, electric characteristics are measured in a state in which the at least five first correction data obtaining samples, at least five second correction data obtaining samples assumed to have electric characteristics equivalent to those of the at least five first correction data obtaining samples, or at least one of the third correction data obtaining samples assumed to have electric characteristics equivalent to those of a part of the at least five first correction data obtaining samples and the other ones of the first correction data obtaining samples are mounted on the test measurement jig. In the third step, the equation determined from the result of measurements in the first and second steps is an equation that assumes correction of the leakage signals of all the ports in each of the standard measurement jig and the test

3

measurement jig.

In other words, if all the ports in which the leakage signals are present in each of the standard measurement jig and the test measurement jig are corrected, it is necessary to prepare an equation that assumes correction of the leakage signals of all the ports. For example, when the leakage is present only between the ports 1 and 2 in an electronic component having three ports, it is sufficient to use three correction data obtaining samples. When the leakage is present between the ports 1 and 2 and between the ports 1 and 3, there is a leakage also between the ports 2 and 3, so that it is necessary to prepare an equation that assumes also correction of the leakage between the ports 2 and 3. In that case, five correction data obtaining samples will be needed.

Preferably, the equation determined in the third step is, in a relative error correction circuit network model in which identical ports are connected with each other and different ports assuming presence of leakage signals are connected, between an S parameter at the standard measurement jig and an S parameter at the test measurement jig in measurement of arbitrary n ports, a T parameter $T_{CA}'$ of the relative error correction circuit network model normalized by arbitrary one element in a T parameter $T_{CA}$ of the circuit network model that is calculated by normalizing $T_{CA}$ with the arbitrary one element in $T_{CA}$ on the following equation:

[Equation 1]

$$\begin{bmatrix} \left(S_{T1}{}^{t} \quad I_{n\times n}\right)\otimes\left(-I_{n\times n} \quad S_{D1}\right) \\ \left(S_{T2}{}^{t} \quad I_{n\times n}\right)\otimes\left(-I_{n\times n} \quad S_{D2}\right) \\ \vdots \\ \left(S_{Tm}{}^{t} \quad I_{n\times n}\right)\otimes\left(-I_{n\times n} \quad S_{Dm}\right) \end{bmatrix}\cdot t_{CA}=0$$

$$t_{CA}=cs[T_{CA}]=\begin{pmatrix} t_{CA11} \\ t_{CA21} \\ \vdots \end{pmatrix}$$

where $\otimes$ is a Kronecker product, cs[] is a column expansion, the suffix t represents a transpose matrix, and $I_{n\times n}$ is an $n \times n$ unit matrix,

that is represented by using: (a) an S parameter $S_{Dm}$ of the m-th correction data obtaining sample measurement values in the standard measurement jig, (b) an S parameter $S_{Tm}$ of the m-th correction data obtaining sample measurement values in the test measurement jig, and (c) the T parameter $T_{CA}$ of the relative error correction circuit network model.

In this case, the precision of correcting measurement errors will be improved by using a relative error correction circuit network in which connection is established between different ports at which the presence of leakage signals is assumed.

Calculation is made by replacing the above [equation 1] with $S_D$ measured in the first step and $S_T$ measured in the second step on the correction data obtaining samples that are identical or can be regarded as being identical and by treating $T_{CA}'$ as an unknown number.

When $T_{CA}'$ of the relative correction circuit network model is determined, the S parameter in the standard measurement jig can be calculated in the fifth step from the S parameter in the test measurement jig measured in the fourth step.

Preferably, the equation by which the electric characteristics are calculated in the fifth step is, in a circuit network model in which identical ports are connected with each other and different ports assuming presence of leakage signals are connected, between an S parameter at the standard measurement jig and an S parameter at the test measurement jig in measurement of arbitrary n ports, $S_D$ calculated based on the following equation:

[Equation 2]

$$S_D = \left(T_{CA11}{}' \cdot S_T + T_{CA12}{}'\right) \cdot \left(T_{CA21}{}' \cdot S_T + T_{CA22}{}'\right)^{-1}$$

that is represented by using: (a) an S parameter $S_D$ that would be obtained when measured in a state in which the electronic component is mounted on the standard measurement jig, (b) an S parameter $S_T$ of the electronic component measurement values in the test measurement jig, and (c) square matrices $T_{CA11}{}'$, $T_{CA12}{}'$, $T_{CA21}{}'$, and $T_{CA22}{}'$ obtained by splitting the T parameter $T_{CA}{}'$ of the relative error correction circuit network model normalized with arbitrary one element in $T_{CA}$ of the relative error correction circuit network model calculated in the third step into n × n.

In this case, by normalizing $T_{CA}$ with arbitrary one element in $T_{CA}$, $T_{CA}{}'$ can be deduced with a good precision from the [equation 1] and, as a result thereof, the S parameter in the standard measurement jig can be calculated from the S parameter in the test measurement jig by using the [equation 2].

Moreover, the present invention provides an electronic component characteristics measuring device constructed in the following manner.

An electronic component characteristics measuring device that calculates, from a result of measuring electric characteristics in a state in which an electronic component having arbitrary n ports of two or more ports is mounted on a test measurement jig, the electric characteristics that would be obtained when measured in a state in which the electronic component is mounted on a standard measurement jig. The electronic component characteristics measuring device includes: (1) equation storing means for storing an equation determined from a first measurement result obtained by measuring electric characteristics in a state in which at least three first correction data obtaining samples having different electric characteristics with each other are mounted on the standard measurement jig and a second measurement result obtained by measuring electric characteristics in a state in which the at least three first correction data obtaining samples, at least three second correction data obtaining samples assumed to have electric characteristics equivalent to those of the at least three first correction data obtaining samples, or at least one third correction data obtaining sample assumed to have electric characteristics equivalent to those of a part of the at least three first correction data obtaining samples and the other ones of the first correction data obtaining samples are mounted on the test measurement jig, where the equation correlates, on one and the same electronic component, measurement values of electric characteristics measured in a state in which the electronic component is mounted on the test measurement jig with measurement values of electric characteristics measured in a state in which the electronic component is mounted on the standard measurement jig, assuming the presence of leakage signals that are directly transmitted between at least two ports of at least one of the standard measurement jig and the test measurement jig without being transmitted to the electronic component connected to the two ports, and (2) electric characteristics estimating means for calculating, from a result of measuring electric characteristics in a state in which an arbitrary electronic component is mounted on the test measurement jig, the electric characteristics that would be obtained when measured in a state in which the electronic component is mounted on the standard measurement jig, by using the equation stored in the equation storing means.

In this case, by using the equation stored in the equation storage means, an estimated value of the electric characteristics in a state of being mounted on the standard measurement jig can be calculated.

Here, the electronic component characteristics measuring device may include a measurement means for measuring the characteristics of the electronic component via the standard measurement jig or the test measurement jig or may include an equation calculation means for deducing an equation stored in the measurement part equation storage means by using all of or a part of the results obtained from measurement by the measurement means.

Preferably, when all the ports at which the leakage signals are present are corrected in each of the base measurement jig and the test measurement jig, the equation stored by the equation storing means is determined from: the first measurement result obtained by measuring electric characteristics in a state in which at least five of the first correction data obtaining samples having different electric characteristics with each other are mounted on the standard measurement jig, and the second measurement result obtained by measuring electric characteristics in a state in which the at least five first correction data obtaining samples, at least five second correction data obtaining samples assumed to have electric characteristics equivalent to those of the at least five first correction data obtaining samples, or at least one of the third correction data obtaining samples assumed to have electric characteristics equivalent to those of a part of the at least five first correction data obtaining samples and the other ones of the first correction data obtaining samples are mounted on the test measurement jig, assuming correction of the leakage signals of all the ports in each of the standard measurement jig and the test measurement jig.

Preferably, the equation stored by the equation storing means is, in a relative error correction circuit network model in which identical ports are connected with each other and different ports assuming presence of leakage signals are connected, between an S parameter at the standard measurement jig and an S parameter at the test measurement jig in measurement of arbitrary n ports, a T parameter $T_{CA}$' of the relative error correction circuit network model normalized by arbitrary one element in a T parameter $T_{CA}$ of the circuit network model that is calculated by normalizing $T_{CA}$ with the arbitrary one element in $T_{CA}$ on the following equation:

[Equation 1]

$$\begin{bmatrix} \left( S_{T1}{}^{t} \quad I_{n \times n} \right) \otimes \left( - I_{n \times n} \quad S_{D1} \right) \\ \left( S_{T2}{}^{t} \quad I_{n \times n} \right) \otimes \left( - I_{n \times n} \quad S_{D2} \right) \\ \vdots \\ \left( S_{Tm}{}^{t} \quad I_{n \times n} \right) \otimes \left( - I_{n \times n} \quad S_{Dm} \right) \end{bmatrix} \cdot t_{CA} = 0$$

$$t_{CA} = cs\left[ T_{CA} \right] = \begin{pmatrix} t_{CA11} \\ t_{CA21} \\ \vdots \end{pmatrix}$$

where $\otimes$ is a Kronecker product, cs[] is a column expansion, the suffix t represents a transpose matrix, and $I_{n \times n}$ is an n × n unit matrix,
that is represented by using: (a) an S parameter $S_{Dm}$ of the m-th correction data obtaining sample measurement values in the standard measurement jig, (b) an S parameter $S_{Tm}$ of the m-th correction data obtaining sample measurement values in the test measurement jig, and (c) the T parameter $T_{CA}$ of the relative error correction circuit network model.

Preferably, the equation stored in the equation storing means and used when the electric characteristics estimating means calculates, from a result of measuring electric characteristics in a state in which an arbitrary electronic component is mounted on the test measurement jig, electric characteristics that would be obtained when measured in a state in which the electronic component is mounted on the standard measurement jig is, in a circuit network model in which identical ports are connected with each other and different ports assuming presence of leakage signals are connected, between an S parameter at the standard measurement jig and an S parameter at the test measurement jig in measurement of arbitrary n ports, $S_D$ calculated based on the following equation:

[Equation 2]

$$S_D = \left( T_{CA11}' \cdot S_T + T_{CA12}' \right) \cdot \left( T_{CA21}' \cdot S_T + T_{CA22}' \right)^{-1}$$

that is represented by using: (a) an S parameter $S_D$ that would be obtained when measured in a state in which the electronic component is mounted on the standard measurement jig, (b) an S parameter $S_T$ of the electronic component measurement values in the test measurement jig, and (c) square matrices $T_{CA11}'$, $T_{CA12}'$, $T_{CA21}'$, and $T_{CA22}'$ obtained by splitting the T parameter $T_{CA}'$ of the relative error correction circuit network model normalized with arbitrary one element in $T_{CA}$ of the relative error correction circuit network model calculated from the first measurement result and the second measurement result into n × n.

Effect of the Invention

According to the present invention, the correction precision can be improved by eliminating the correction errors caused by leakage signal components between the ports of the measurement jigs. This can improve the yield ratio of the electronic components and ensure highly precise characteristics. Also, even if the leakage signal components increase by scale reduction of the electronic components, the scale reduction of the electronic components can be easily met by improving the correction precision. Further, there will be no need to design and manufacture the measurement jigs by paying deliberate consideration to the leakage signals, whereby cost reduction can be achieved.

BRIEF EXPLANATION OF DRAWINGS

FIG. 1 is a signal flow diagram of a 2-port measurement system (conventional example).
FIG. 2 is a signal flow diagram of a 2-port measurement system (present invention).
FIG. 3 is a block diagram of a 3-port measurement system (present invention).
FIG. 4 is a descriptive view showing a measurement state (Example).
FIG. 5 is a descriptive view of a correction data obtaining sample (Example).
FIG. 6a is a graph showing a relative correction result (Example).
FIG. 6b is a graph showing a relative correction result (conventional example).
FIG. 7a is a graph showing a relative correction result (Example).
FIG. 7b is a graph showing a relative correction result (conventional example).
FIG. 8 is a descriptive view of a measurement system.
FIG. 9 is a 2-terminal pair circuit diagram showing a basic principle of the relative correction method (conventional example).
FIG. 10 is a 2-terminal pair circuit diagram showing a basic principle of the relative correction method (conventional example).
FIG. 11 is a descriptive view of a leakage signal.

DESCRIPTION OF REFERENCE SYMBOLS

20, 20a    standard measurement jig
20x        leakage signal
21, 21a    terminal
30, 30a    test measurement jig
30x        leakage signal
31, 31a    terminal
32, 32a    relative correction adaptor

BEST MODE FOR CARRYING OUT THE INVENTION

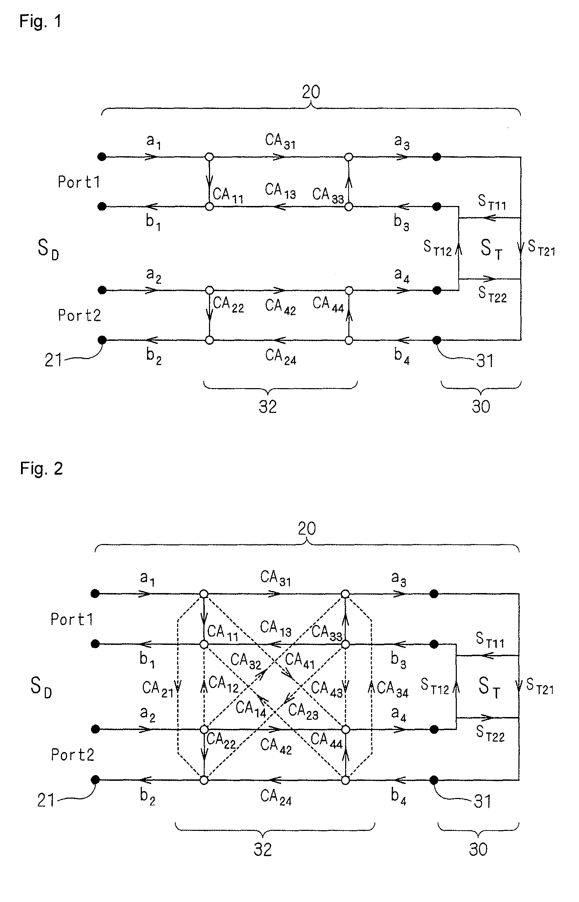

Hereinafter, embodiments of the present invention will be described with reference to FIGS. 1 to 11.

<Measurement system>

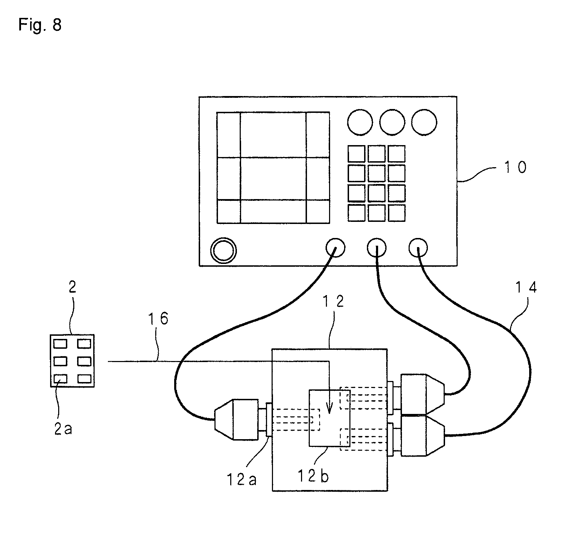

Referring to FIG. 8, electric characteristics of an electronic component 2 (for example, a surface acoustic wave filter which is a high-frequency passive electronic component) are measured by a measuring device 10 (for example, a network analyzer) in a state in which the electronic component 2 is mounted on a measurement jig 12. Connection is established between a coaxial connector 12a of the measurement jig 12 and the measuring device 10 by a coaxial cable 14. As shown by an arrow 16, when the electronic component 2 is mounted on a mounting portion 12b of the measurement jig 12, a terminal 2a of the electronic component 2 is electrically connected to the measuring device 10. The measuring device 10 measures the electric characteristics of terminal 2a of the electronic component 2 by inputting a signal to a certain terminal and detecting an output signal from another terminal.

In accordance with a predetermined program, the measuring device 10 performs an operation process on measurement data so as to calculate the electric characteristics of the electronic component 2. In this case, the measuring device 10 reads out needed data such as the measurement values and parameters used for operation from an internal memory or recording medium or reads out needed data by communicating with an external apparatus (for example, a server). The measuring device 10 can be split into a plurality of apparatus. For example, the measuring device 10 may be split into a measurement part that performs measurement only and an operation part that receives input of measurement data and performs an operation process or determination of good or bad.

Here, it is sufficient that the measuring device 10 can store data of equations for performing a later-mentioned relative correction in an equation storage means such as a memory and can calculate an estimated value of the electric characteristics by relative correction using the data on an arbitrary electronic component with an electric characteristics estimation means such as a CPU. In other words, the measuring device 10 may be one that determines an equation for performing the relative correction by performing measurements and operations itself, one that determines an equation for performing the relative correction by using data that are measured in another measuring device, or furthermore one that stores data of equations for performing the relative correction that are determined in another measuring device and calculates an estimated value of the electric characteristics by relative correction on an arbitrary electronic component by using the data.

It is difficult to fabricate a plurality of measurement jigs 12 having identical characteristics. For this reason, even with an identical electronic component 2, there will be variation in the characteristics for each measurement jig if the measurement jig 12 used for measurement differs, whereby the measurement results will also differ. For example, the measurement results will differ between a measurement jig (standard measurement jig) used for ensuring the electric characteristics to users and a measurement jig (test measurement jig) used in measurement for selecting good products in the step of manufacturing the electronic component. Such a difference in the measurement values between the measurement jigs can be corrected by the relative correction method.

<Relative correction method of conventional example>

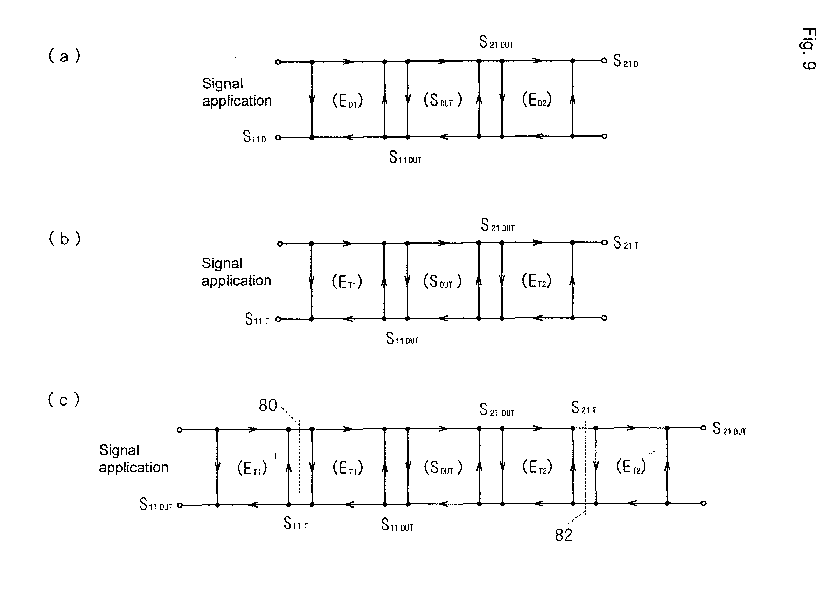

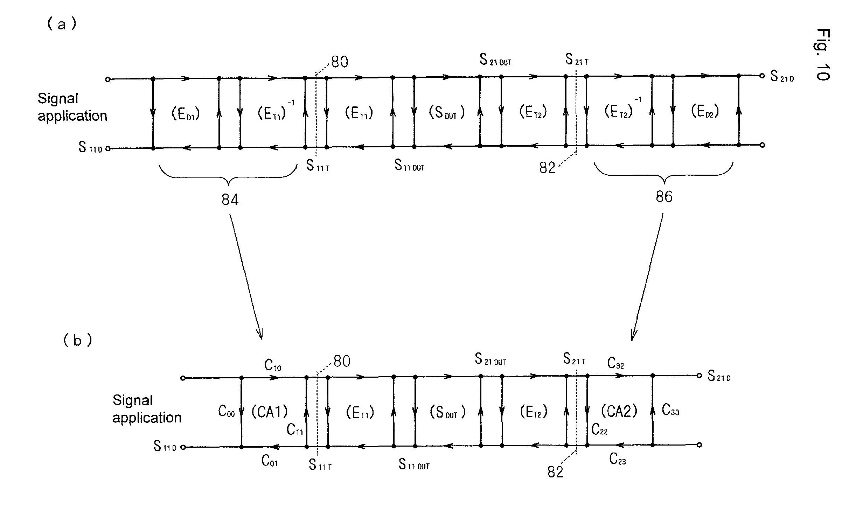

Next, a basic principle of a relative correction method of a conventional example will be described with reference to FIGS. 9 and 10. In the following, for the sake of simplification, description will be given by raising a 2-terminal pair circuit as an example on the electric characteristics between two ports; however, this can be extended also to an n-terminal pair circuit (n is an integer of 1, 3, or more than 3).

FIG. 9(a) shows a 2-terminal pair circuit of a standard measurement jig on which an electronic component of two ports (hereinafter, referred to a "sample DUT") is mounted. The characteristics of the sample DUT are represented by a scattering matrix ($S_{DUT}$). The error characteristics between the coaxial connector and the port of the sample DUT in the standard measurement jig are represented by scattering matrices ($E_{D1}$), ($E_{D2}$). At the terminals on both sides of the circuit, measurement values in a state in which the sample DUT is mounted on the standard measurement jig (hereinafter, also referred to as "standard measurement jig measurement values") $S_{11D}$, $S_{21D}$ are obtained.

FIG. 9(b) shows a 2-terminal pair circuit of a test measurement jig on which a sample DUT is mounted. The characteristics of the sample DUT are represented by a scattering matrix ($S_{DUT}$). The error characteristics between the coaxial connector and the port of the sample DUT in the test measurement jig are represented by scattering matrices ($E_{T1}$), ($E_{T2}$). At the terminals on both sides of the circuit, measurement values in a state in which the sample DUT is mounted on the test measurement jig (hereinafter, also referred to as "test measurement jig measurement values") $S_{11T}$, $S_{21T}$ are obtained.

FIG. 9(c) shows a state in which adaptors ($E_{T1}$)$^{-1}$, ($E_{T2}$)$^{-1}$ that neutralize the error characteristics ($E_{T1}$), ($E_{T2}$) are connected to both sides of the circuit of FIG. 9(b). Theoretically, these adaptors ($E_{T1}$)$^{-1}$, ($E_{T2}$)$^{-1}$ are obtained by converting the scattering matrices ($E_{T1}$), ($E_{T2}$) of the error characteristics into transmission matrices, determining the inverse matrices thereof, and converting them into the scattering matrices again. At the boundary parts 80, 82 between the error characteristics ($E_{T1}$), ($E_{T2}$) and the adaptors ($E_{T1}$)$^{-1}$, ($E_{T2}$)$^{-1}$, test measurement jig measurement values $S_{11T}$, $S_{21T}$ are obtained that are measured by mounting the sample DUT on the test measurement jig. At the terminals on both sides of the circuit of FIG. 9(c), the errors of the test measurement jig are removed, and the measurement values $S_{11DUT}$, $S_{21DUT}$ of the sample DUT itself are obtained.

Since the circuit of FIG. 9(c) is equivalent to the sample DUT alone, a state such as shown in FIG. 10(a) will appear when the scattering matrices ($E_{D1}$), ($E_{D2}$) of the error characteristics of the standard measurement jig are connected to both sides in the same manner as in FIG. 9(a).

Assuming that the scattering matrix obtained by synthesizing ($E_{D1}$), ($E_{T1}$)$^{-1}$ shown by a reference symbol 84 in FIG. 10(a) is (CA1) and that the scattering matrix obtained by synthesizing ($E_{T2}$)$^{-1}$, ($E_{D2}$) shown by a reference symbol 86 is (CA2), a state such as shown in FIG. 10(b) will appear. These scattering matrices (CA1), (CA2) are what is known as "relative correction adaptors", and correlates the test measurement jig measurement values $S_{11T}$, $S_{21T}$ to the standard measurement jig measurement values $S_{11D}$, $S_{21D}$. Therefore, when the relative correction adaptors (CA1), (CA2) are determined, the standard measurement jig measurement values $S_{11D}$, $S_{21D}$ can be calculated (estimated) by using the relative correction adaptors (CA1), (CA2) from the test measurement jig measurement values $S_{11T}$, $S_{21T}$ in a state in which an arbitrary electronic component is mounted on the test measurement jig.

The relative correction adaptors (CA1), (CA2) each include four coefficients $c_{00}$, $c_{01}$, $c_{10}$, $c_{11}$; $c_{22}$, $c_{23}$, $c_{32}$, $c_{33}$; however, the reciprocity theorem makes $c_{01} = c_{10}$, $c_{23} = c_{32}$. Therefore, the coefficients $c_{00}$, $c_{01}$, $c_{10}$, $c_{11}$; $c_{22}$, $c_{23}$, $c_{32}$, $c_{33}$ can be determined by using measurement values measured by mounting three kinds of 1-port standard samples (correction data obtaining samples) having different characteristics on the standard measurement jig and the standard measurement jig between respective ports.

The basic characteristics of the correction data obtaining samples for calculating the relative correction adaptors must be such that the transmission coefficient between respective ports is sufficiently small and that the reflection coefficient characteristics at the same port and at the same frequency differ respectively between the correction data obtaining samples. Since it is a reflection coefficient, forming an Open, a Short-circuit, and an End terminal facilitates fulfilling the basic characteristics of the above-described correction data obtaining samples. Also, the outer form of the correction data obtaining samples is preferably an outer form that can be mounted on the measurement jigs in the same manner as the correction object samples.

The Open, the Short-circuit, and the End terminal between respective ports can be realized by connecting the signal line of a package to the ground with a lead wire, a chip resistor, or the like in the inside of the package or the like that is identical to the sample serving as an object of measurement. However, by this method, when the sample serving as an object of measurement is reduced in scale, it will be difficult to arrange members such as the chip resistor in the inside of the package or the like, whereby the correction data obtaining samples cannot be fabricated, raising, as a result thereof, a possibility that the selection of good products cannot be carried out by using the relative correction method.

As a countermeasure against this, the correction data obtaining samples are fabricated by using the step of producing the sample (electronic component) serving as an object of measurement. In this case, the correction data obtaining samples may be fabricated by using any of the production line for producing electronic components serving as commercial products, the production line for experimentally producing test samples of electronic components, and the mode in which the two are combined.

Moreover, it is sufficient that the correction data obtaining samples mounted on the standard measurement jig and the correction data obtaining samples mounted on the test measurement jig have the same electric characteristics in principle, the samples may not be the same. For example, the relative correction adaptors can be deduced also by preparing a plurality of correction data obtaining samples that can be regarded as having the same electric characteristics and mounting separate correction data obtaining samples arbitrarily selected from the prepared correction data obtaining samples respectively on the standard measurement jig and the test measurement jig for making measurements.

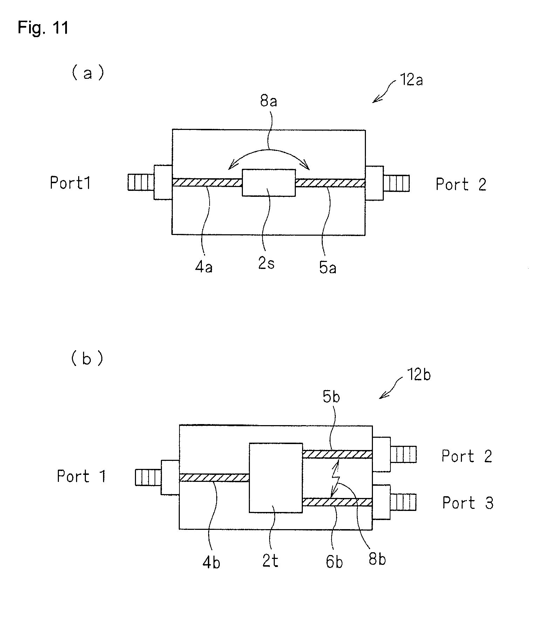

In the meantime, as shown by an arrow 8a in the descriptive view of FIG. 11(a), not a least amount of leakage signal components that are directly transmitted between the signal paths 4a, 5a of the ports 1, 2 of the measurement jig 12a and are not transmitted between the ports 1, 2 of the electronic component 2s mounted on the measurement jig 12a are present. Also, as shown by an arrow 8b in the descriptive view of FIG. 11(b), the leakage signal components that are directly transmitted between the close ports 2, 3 of the measurement jig 12b will be large. The conventional relative correction methods are based on a circuit network model that does not consider such leakage signals in the measurement jigs at all. For this reason, by the conventional relative correction methods, the correction errors caused by the leakage signals will remain.

<Basic principle of the present invention>

Next, the basic principle of the present invention will be described with reference to FIGS. 1 to 3.

FIG. 1 is a signal flow diagram obtained by rewriting a 2-terminal pair circuit used in the relative correction method of a conventional example for the sake of comparison. The reference symbol 20 denotes a part corresponding to the standard measurement jig, and the reference symbol 21 denotes a terminal corresponding to the coaxial connector of the standard measurement jig. The reference symbol 30 denotes a part corresponding to the test measurement jig, and the reference symbol 31 denotes a terminal corresponding to the coaxial connector of the test measurement jig. The relative correction adaptors 32 are connected independently from each other for each of the ports 1, 2 between the terminal 21 of the standard measurement jig 20 and the terminal 31 of the test measurement jig 30.

In contrast, in the relative correction method of the present invention, a signal flow diagram shown in FIG. 2 is used. Specifically, in the present invention, for the relative correction adaptors 32 connected between the terminal 21 of the standard measurement jig 20 and the terminal 31 of the test measurement jig 30 for the ports 1, 2, parts shown by broken lines are added to the parts identical to those of the conventional examples shown by solid lines. By these broken-line parts, presence of leakage signals that are directly transmitted between the ports, that is, leakage signals that are not transmitted to the electronic component connected to the ports, can be assumed between the ports of at least one of the standard measurement jig and the test measurement jig.

In a greater detail, $CA_{12}$ is connected between the input signal ($a_2$) to the port 2 of the standard measurement jig and the output signal ($b_1$) from the port 1 of the standard measurement jig. $CA_{21}$ is connected between the input signal ($a_1$) to the port 1 of the standard measurement jig and the output signal ($b_2$) from the port 2 of the standard measurement jig.

$CA_{34}$ is connected between the output signal ($b_4$) from the port 2 of the test measurement jig and the input signal ($a_3$) to the port 1 of the test measurement jig. $CA_{43}$ is connected between the output signal ($b_3$) from the port 1 of the test measurement jig and the input signal ($a_4$) to the port 2 of the test measurement jig.

$CA_{14}$ is connected between the output signal ($b_4$) from the port 2 of the test measurement jig and the output signal ($b_1$) from the port 1 of the standard measurement jig. $CA_{41}$ is connected between the input signal ($a_1$) to the port

1 of the standard measurement jig and the input signal ($a_4$) to the port 2 of the test measurement jig.

CA$_{23}$ is connected between the output signal ($b_3$) from the port 1 of the test measurement jig and the input signal ($b_2$) from the port 2 of the standard measurement jig. CA$_{32}$ is connected between the input signal ($a_2$) to the port 2 of the standard measurement jig and the input signal ($a_3$) to the port 1 of the test measurement jig.

From FIG. 2, the following three equations hold.

[Equation 3]

$$\begin{pmatrix} b_1 \\ b_2 \\ a_1 \\ a_2 \end{pmatrix} = \begin{pmatrix} t_{CA11} & t_{CA12} & t_{CA13} & t_{CA14} \\ t_{CA21} & t_{CA22} & t_{CA23} & t_{CA24} \\ t_{CA31} & t_{CA32} & t_{CA33} & t_{CA34} \\ t_{CA41} & t_{CA42} & t_{CA43} & t_{CA44} \end{pmatrix} \cdot \begin{pmatrix} b_3 \\ b_4 \\ a_3 \\ a_4 \end{pmatrix}$$

[Equation 4]

$$\begin{pmatrix} b_3 \\ b_4 \end{pmatrix} = S_T \cdot \begin{pmatrix} a_3 \\ a_4 \end{pmatrix}$$

[Equation 5]

$$\begin{pmatrix} b_1 \\ b_2 \end{pmatrix} = S_D \cdot \begin{pmatrix} a_1 \\ a_2 \end{pmatrix}$$

Here, the smaller matrices of square matrices obtained by splitting the T parameter $T_{CA}$

[Equation 6]

$$T_{CA} = \begin{pmatrix} t_{CA11} & t_{CA12} & t_{CA13} & t_{CA14} \\ t_{CA21} & t_{CA22} & t_{CA23} & t_{CA24} \\ t_{CA31} & t_{CA32} & t_{CA33} & t_{CA34} \\ t_{CA41} & t_{CA42} & t_{CA43} & t_{CA44} \end{pmatrix}$$

which is a relative correction adaptor 32 into 2 x 2 are assumed to be $T_{CA11}$, $T_{CA12}$, $T_{CA21}$, and $T_{CA22}$. Specifically, it is set that

[Equation 7]

$$T_{CA11} = \begin{pmatrix} t_{CA11} & t_{CA12} \\ t_{CA21} & t_{CA22} \end{pmatrix} \qquad T_{CA12} = \begin{pmatrix} t_{CA13} & t_{CA14} \\ t_{CA23} & t_{CA24} \end{pmatrix}$$

$$T_{CA21} = \begin{pmatrix} t_{CA31} & t_{CA32} \\ t_{CA41} & t_{CA42} \end{pmatrix} \qquad T_{CA22} = \begin{pmatrix} t_{CA33} & t_{CA34} \\ t_{CA43} & t_{CA44} \end{pmatrix}$$

The [equation 3] is represented as follows by using the [equation 7].

[Equation 8a]

$$\begin{pmatrix} b_1 \\ b_2 \end{pmatrix} = T_{CA11} \cdot \begin{pmatrix} b_3 \\ b_4 \end{pmatrix} + T_{CA12} \cdot \begin{pmatrix} a_3 \\ a_4 \end{pmatrix}$$

[Equation 8b]

$$\begin{pmatrix} a_1 \\ a_2 \end{pmatrix} = T_{CA21} \cdot \begin{pmatrix} b_3 \\ b_4 \end{pmatrix} + T_{CA22} \cdot \begin{pmatrix} a_3 \\ a_4 \end{pmatrix}$$

By replacing the [equation 8a] with the [equation 5] and further replacing with the [equation 8b], the following equation is obtained.

[Equation 9]

$$T_{CA11} \cdot \begin{pmatrix} b_3 \\ b_4 \end{pmatrix} + T_{CA12} \cdot \begin{pmatrix} a_3 \\ a_4 \end{pmatrix} = S_D \cdot \left[ T_{CA21} \cdot \begin{pmatrix} b_3 \\ b_4 \end{pmatrix} + T_{CA22} \cdot \begin{pmatrix} a_3 \\ a_4 \end{pmatrix} \right]$$

By replacing the [equation 9] with the [equation 4], the following equation is obtained.

[Equation 10]

$$T_{CA11} \cdot S_T + T_{CA12} = S_D \cdot \left( T_{CA21} \cdot S_T + T_{CA22} \right)$$

By multiplying this [equation 10] with $(T_{CA21} \cdot S_T + T_{CA22})^{-1}$ from the right, the following is obtained.

[Equation 11]

$$S_D = \left(T_{CA11} \cdot S_T + T_{CA12}\right) \cdot \left(T_{CA21} \cdot S_T + T_{CA22}\right)^{-1}$$

whereby the [equation 11] is deduced.

When this [equation 11] is transformed into a linear combination to $T_{CA}$, the following is obtained.

[Equation 12]

$$\left[\left(S_T{}^t \quad I_2\right) \otimes \left(-I_2 \quad S_D\right)\right] \cdot t_{CA} = A_{4 \times 16} \cdot t_{CA} = 0$$

[Equation 13]

$$t_{CA} = cs[T_{CA}] = \begin{pmatrix} t_{CA11} \\ t_{CA21} \\ \vdots \\ t_{CA44} \end{pmatrix}$$

Here, the [equation 14a]

$$\otimes$$

is a Kronecker product.
The [equation 14b]

$$cs[\quad]$$

is a column expansion.

The suffix t is a transpose matrix.

$I_2$ is a 2 × 2 unit matrix. Hereinafter, it is defined that In is an n × n unit matrix.

When $t_{CA}$ is normalized by one element, for example, - $t_{CA11}$, the [equation 12] will be

[Equation 15]

$$\frac{1}{-t_{CA11}} \cdot A_{4x16} \cdot t_{CA} = A_{4x16} \cdot \begin{pmatrix} -1 \\ t_{CA}' \end{pmatrix} = \begin{pmatrix} u_{4x1} & B_{4x15} \end{pmatrix} \cdot \begin{pmatrix} -1 \\ t_{CA}' \end{pmatrix} = -u_{4x1} + B_{4x15} \cdot t_{CA}' = 0$$

Here, $A_{4\times16}$ is a 4 × 16 matrix; $u_{4\times1}$ is a 4 × 1 matrix, and $B_{4\times15}$ is a 4 × 15 matrix.

Therefore, the following holds.

[Equation 16]

$$B_{4\times15} \cdot t_{CA}' = u_{4\times1}$$

[Equation 17]

$$t_{CA}' = \begin{pmatrix} -\dfrac{t_{CA21}}{t_{CA11}} \\ -\dfrac{t_{CA31}}{t_{CA11}} \\ \vdots \\ -\dfrac{t_{CA44}}{t_{CA11}} \end{pmatrix}$$

The [equation 16] and [equation 17] show that four linear equations to $t_{CA}'$ are deduced by measuring DUT with the standard measurement jig and the test measurement jig.

When it is assumed that the leakage error relative correction adaptor $t_{CA}'$ is unknown, $t_{CA}'$ is deduced by using DUT as a correction data obtaining sample and measuring some correction data obtaining samples because the [equation 16] and [equation 17] represent four linear simultaneous equations to $t_{CA}'$. When $N_{std}$ correction data obtaining samples are measured, the [equation 16] and [equation 17] are represented by the following equations.

[Equation 18]

$$C_{4N_{std}\times15} \cdot t_{CA}' = v_{4N_{std}}$$

[Equation 19]

$$C_{4N_{std}\times 15} = \begin{pmatrix} B_{1\ 4\times 15} \\ \vdots \\ B_{N_{std}\ 4\times 15} \end{pmatrix}$$

[Equation 20]

$$v_{4N_{std}} = \begin{pmatrix} u_{1\ 4} \\ \vdots \\ u_{N_{std}\ 4} \end{pmatrix}$$

Since $C_{4Nstd\times 15}$ and $v_{4N}$ are measurement values, errors are present. When it is assumed that the distribution of errors is a normal distribution, $t_{CA}'$ is determined by solving the minimum square problem. In order that rank $[C_{4Nstd\times 15}] \geq 15$ (the number of unknown numbers of $t_{CA}'$), it is sufficient that five or more correction data obtaining samples having different characteristics are prepared. Depending on the measurement environment, the precision of the solution of $t_{CA}'$ will be improved by considering the difference of the dispersion of measurement values on the [equation 18]. Also, when the distribution of errors is not a normal distribution, $t_{CA}'$ is determined by solving with use of the maximum-likelihood method.

By replacing the [equation 11] with $t_{CA}'$ determined by the above-described method, the standard measurement jig measurement value can be estimated from the test measurement jig measurement value.

<As to the normalization>

Next, an influence on the relational equation [equation 11] of the standard measurement jig measurement value and the test measurement jig measurement value obtained by normalizing $T_{CA}$ will be considered.

When $-t_{CA11}$ is set to be $\alpha$, the [equation 11] is transformed as follows.

[Equation 21]

$$S_D = \left(T_{CA11}\cdot S_T + T_{CA12}\right)\cdot\left(T_{CA21}\cdot S_T + T_{CA22}\right)^{-1}$$

$$= \left(\alpha\cdot T_{CA11}'\cdot S_T + \alpha\cdot T_{CA12}'\right)\cdot\left(\alpha\cdot T_{CA21}'\cdot S_T + \alpha\cdot T_{CA22}'\right)^{-1}$$

$$= \left(T_{CA11}'\cdot S_T + T_{CA12}'\right)\cdot\left(T_{CA21}'\cdot S_T + T_{CA22}'\right)^{-1}$$

[Equation 22]

$$T_{CA11}{}' = \begin{pmatrix} -1 & -\dfrac{t_{CA12}}{t_{CA11}} \\ -\dfrac{t_{CA21}}{t_{CA11}} & -\dfrac{t_{CA22}}{t_{CA11}} \end{pmatrix} \qquad T_{CA12}{}' = \begin{pmatrix} -\dfrac{t_{CA13}}{t_{CA11}} & -\dfrac{t_{CA14}}{t_{CA11}} \\ -\dfrac{t_{CA23}}{t_{CA11}} & -\dfrac{t_{CA24}}{t_{CA11}} \end{pmatrix}$$

$$T_{CA21}{}' = \begin{pmatrix} -\dfrac{t_{CA31}}{t_{CA11}} & -\dfrac{t_{CA32}}{t_{CA11}} \\ -\dfrac{t_{CA41}}{t_{CA11}} & -\dfrac{t_{CA42}}{t_{CA11}} \end{pmatrix} \qquad T_{CA22}{}' = \begin{pmatrix} -\dfrac{t_{CA33}}{t_{CA11}} & -\dfrac{t_{CA34}}{t_{CA11}} \\ -\dfrac{t_{CA43}}{t_{CA11}} & -\dfrac{t_{CA44}}{t_{CA11}} \end{pmatrix}$$

The [equation 21] and [equation 22] show that the standard measurement jig measurement value can be estimated from the test measurement jig measurement value even by using $t_{CA}'$ deduced by normalization. Therefore, it can be said that there is no problem on the normalization.

Here, an example has been described in which $-t_{CA11}$ is used as an element of the T parameter that will be a standard of normalization. Actually, however, it is desirable to select an element that does not assume a value around zero.

<Extension to N-port measurement system>

Next, extension to an arbitrary N-port measurement system will be described.

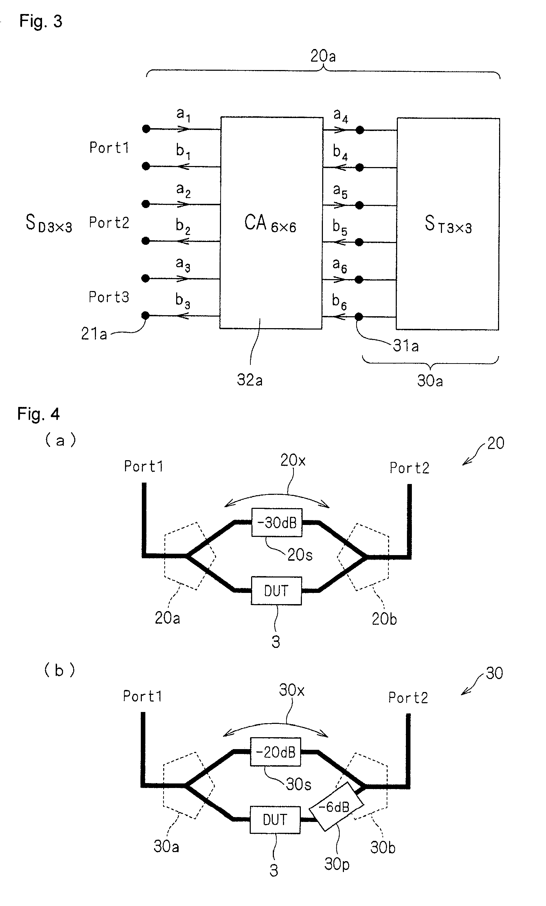

First, a 3-port measurement system will be described. FIG. 3 shows a block diagram of the relative correction method in which model leakage signals in the 3-port measurements are shown. The meaning of each reference symbol is the same as in the 2-port example (FIGS. 1 and 2).

In FIG. 3, the relationship between $S_T$ and $S_D$ is represented by the following equation when the T parameter $T_{CA}$ of the leakage signal relative correction circuit network is used. This is approximately the same as in the 2-port case except that each matrix is a $3 \times 3$ matrix.

[Equation 23]

$$S_D = \left(T_{CA11} \cdot S_T + T_{CA12}\right) \cdot \left(T_{CA21} \cdot S_T + T_{CA22}\right)^{-1}$$

[Equation 24]

$$T_{CA} = \begin{pmatrix} t_{CA11} & t_{CA12} & t_{CA13} & t_{CA14} & t_{CA15} & t_{CA16} \\ t_{CA21} & t_{CA22} & t_{CA23} & t_{CA24} & t_{CA25} & t_{CA26} \\ t_{CA31} & t_{CA32} & t_{CA33} & t_{CA43} & t_{CA35} & t_{CA36} \\ t_{CA41} & t_{CA42} & t_{CA43} & t_{CA44} & t_{CA45} & t_{CA46} \\ t_{CA51} & t_{CA52} & t_{CA53} & t_{CA54} & t_{CA55} & t_{CA56} \\ t_{CA61} & t_{CA62} & t_{CA63} & t_{CA64} & t_{CA65} & t_{CA66} \end{pmatrix}$$

[Equation 25]

$$T_{CA11} = \begin{pmatrix} t_{CA11} & t_{CA12} & t_{CA13} \\ t_{CA21} & t_{CA22} & t_{CA23} \\ t_{CA31} & t_{CA32} & t_{CA33} \end{pmatrix} \qquad T_{CA12} = \begin{pmatrix} t_{CA14} & t_{CA15} & t_{CA16} \\ t_{CA24} & t_{CA25} & t_{CA26} \\ t_{CA34} & t_{CA35} & t_{CA36} \end{pmatrix}$$

$$T_{CA21} = \begin{pmatrix} t_{CA41} & t_{CA42} & t_{CA43} \\ t_{CA51} & t_{CA52} & t_{CA53} \\ t_{CA61} & t_{CA62} & t_{CA63} \end{pmatrix} \qquad T_{CA22} = \begin{pmatrix} t_{CA44} & t_{CA45} & t_{CA46} \\ t_{CA54} & t_{CA55} & t_{CA56} \\ t_{CA64} & t_{CA65} & t_{CA66} \end{pmatrix}$$

The following equation is determined by a procedure similar to the 2-port case.

[Equation 26]

$$\left[ \left( S_T i^t \quad I_3 \right) \otimes \left( -I_3 \quad S_D i \right) \right] \cdot t_{CA} = A_{9 \times 36} \cdot t_{CA} = 0$$

[Equation 27]

$$t_{CA} = cs[T_{CA}] = \begin{pmatrix} t_{CA11} \\ t_{CA21} \\ \vdots \\ t_{CA66} \end{pmatrix}$$

The [equation 26] and [equation 27] are completely the same as the [equation 12] and [equation 13] of the 2-port case, although the dimension is different. Therefore, by performing normalization in the same manner, it can be turned into a form of the observation equation in the least square method. Then, $t_{CA}'$ can be determined by measuring five or more correction data obtaining samples having different characteristics with use of the standard measurement jig and the test measurement jig and replacing with the measurement value thereof.

In other words, the solution of the leakage error relative correction adaptors in the 3-port case can be regarded as extension of the method in the 2-port case.

The same applies also to a case of four or more ports, and the present technique can be extended to an arbitrary N-port case.

<Example>

In order to perform relative correction of leakage signals between the ports in a 2-port case, two measurement states including the leakage signals between the ports, namely a standard state and a test state, were constructed with a coaxial rail.

FIG. 4 shows a model view of the measurement system. FIG. 4(a) is the standard state, and FIG. 4(b) is the test state. In both states, as shown by arrow 20x, 30x, a path that does not pass through DUT3, namely leakage signals, are generated by distributors 20a, 20b; 30a, 30b. The leakage signal level is adjusted by attenuators 20s, 30s, whereby the standard state was set to be about -37 dB, and the test state was set to be about -27 dB. Also, in the test state, an attenuator 30p of -6 dB is further connected to the DUT3 side, whereby the loss is increased relative to the standard state.

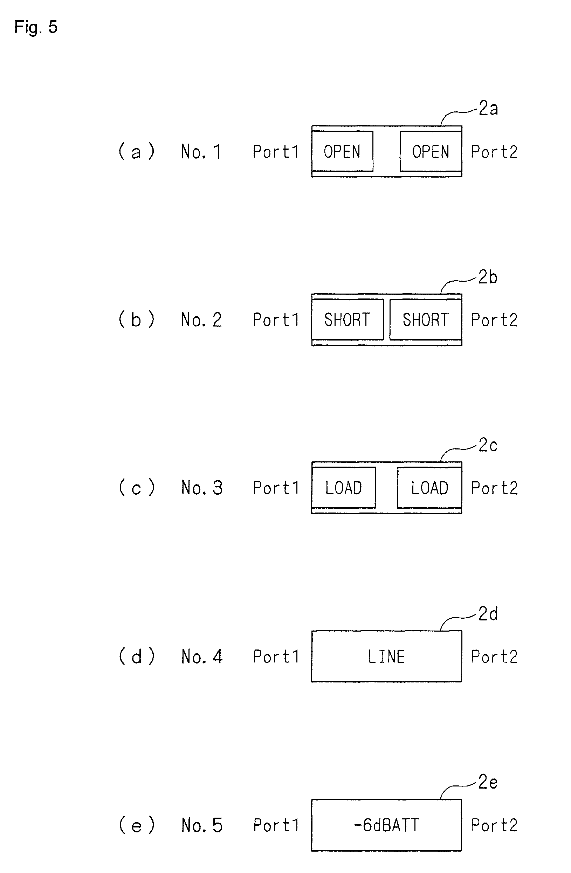

FIG. 5 shows correction data obtaining samples. Five 2-port correction data obtaining samples 2a to 2e were prepared. As to the correction data obtaining samples 2a to 2c of OPEN/OPEN, SHORT/SHORT, LOAD/LOAD shown in FIGS. 5(a) to 5(c), two pieces of a CAL kit (85952B) were simultaneously connected. The correction data obtaining sample 2d of LINE of FIG. 5(d) is a 3.5 mm male-female connector. As the correction data obtaining sample 2e of -6dBATT of FIG. 5(e), an attenuator manufactured by MKT Taisei is used. The values themselves of the electric characteristics of the correction data obtaining samples 2a to 2e are unknown, so that only the measurement values in the standard state and the test state in which the samples were mounted on the measurement jigs were used to deduce the parameter of the relative correction circuit network.

The other experimental conditions are as follows.

[Measurement device] E8364B (Agilent Technologies)

[Measurement frequency] 500 MHz to 2 GHz

[Middle frequency] 100 Hz

[DUT] -3BATT (MKT Taisei)

By using the deduced parameter of the relative correction circuit network, an estimated value of the electric characteristics in a state in which the samples were mounted on the standard measurement jig was calculated by the relative correction method from the measurement values in a state in which the samples were mounted on the test measurement jig.

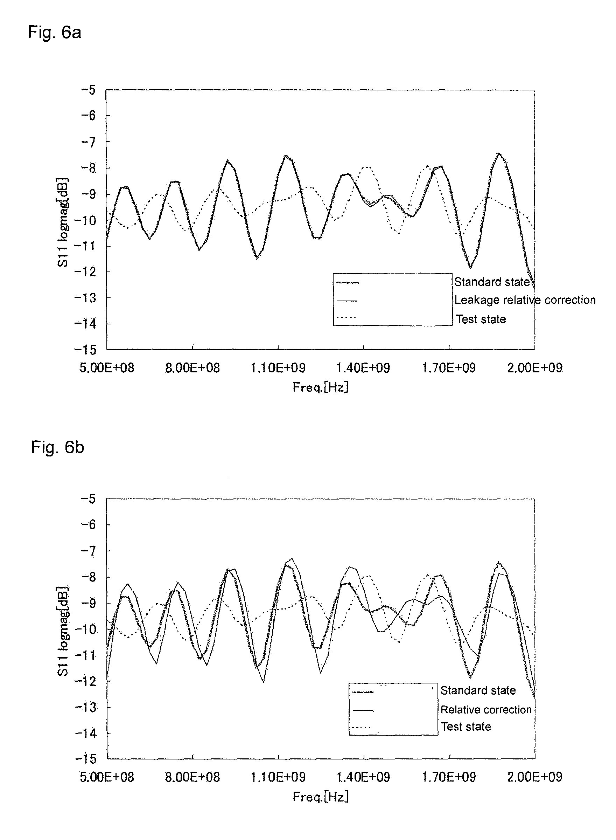

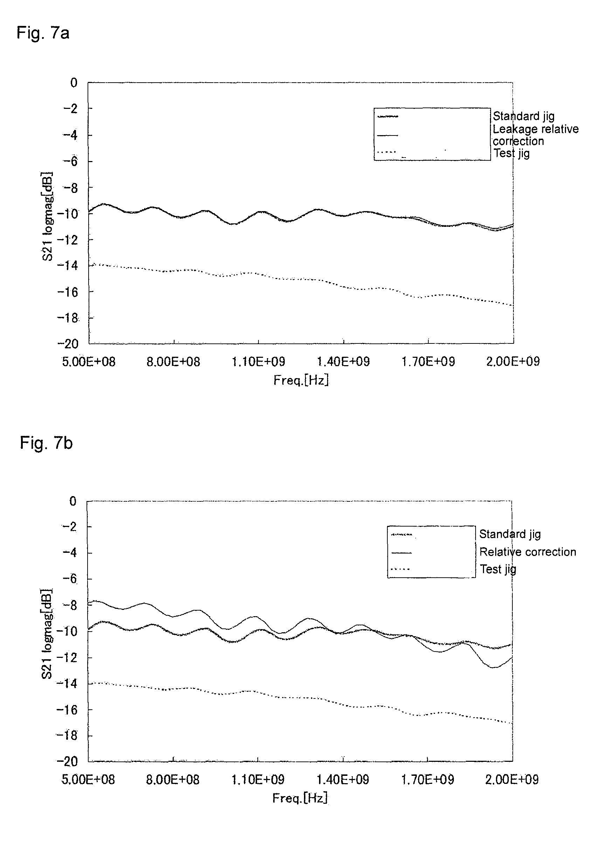

FIGS. 6a and 7a show a graph of the correction result of $S_{11}$ and $S_{21}$, respectively. For the sake of comparison, FIGS. 6b and 7b show a graph of the correction result of $S_{11}$ and $S_{21}$, respectively, in the case in which relative correction adaptors of the conventional example that do not consider the leakage signals between the ports are used. In the Figures, "standard measurement jig" represents a measurement value in a state of being mounted on the standard measurement jig; "test measurement jig" represents a measurement value in a state of being mounted on the test measurement jig; "relative correction" represents an estimated value of the electric characteristics in the state of being mounted on the standard measurement jig that is calculated from the measurement value in the state of being mounted on the test measurement jig by the relative correction method of the conventional example; and "leakage relative correction" represents an estimated value of the electric characteristics in the state of being mounted on the standard measurement jig that is calculated from the measurement value in the state of being mounted on the test measurement jig by the relative correction method of the present invention.

In the conventional example, it is not possible to make a correction including the leakage signals in a measurement system including the leakage signals such as in FIG. 4, so that correction errors will remain as shown in FIGS. 6b and 7b. In contrast, referring to FIGS. 6a and 7a, in the present invention, it will be understood that the correction is made at a good precision even in the case of including the leakage signals. From this result, the present invention can expect sufficient effects in actual measurement including the leakage signals.

Here, correction of measurement errors can be made in which the frequency characteristics of $T_{CA}'$ are also considered, by deducing $T_{CA}'$ for each frequency within the measurement frequency region. In other words, insurance of the characteristics at a high precision can be provided by determining $T_{CA}'$ at the frequency at which the commercial products are actually used, and making an error correction based on that.

Further, by performing processing as one circuit network by combining with correction data of a measurement device such as a network analyzer, the correction calculation time can be reduced. Accordingly, the commercial products can be measured at a higher speed at the time of mass production.

<Others>

When it is known that the leakage signals are present only between two specific ports (for example, between ports 1, 2) and the leakage signals are absent between other ports (for example, between ports 1, 3 or between ports 2, 3) in a 3-port measurement system, the number of unknown numbers will decrease. Therefore, the relative correction adaptors can be determined from the measurement values of at least three correction data obtaining samples.

Moreover, even in the case of using the standard measurement jig and the test measurement jig in which leakage signals are absent, the relative correction method of the present invention can be applied. In this case, the relative correction components will be zero for the leakage signals, so that the correction precision will be of the same degree as or more than that of the relative correction method of a conventional example.

Therefore, the relative correction method of the present invention can be applied irrespective of the presence or absence of leakage signals in the measurement jigs.

<Summary>

Conventionally, a standard measurement jig measurement value is estimated by deducing, for each port, a scattering matrix (relative correction adaptor) obtained by synthesizing a scattering matrix that removes test measurement jig errors and a scattering matrix of standard measurement jig errors and synthesizing the resultant to a scattering matrix of test measurement jig measurement value.

In contrast, for the relative correction adaptor of the present invention, a model relative correction adaptor made to include leakage signal components that are directly transmitted between the ports of the measurement jigs without the intermediary of DUT is used as shown by broken lines in FIG. 2. For this reason, the correction errors caused by leakage signal components are not generated. The relative correction adaptor of the present invention is deduced by measuring, on the standard measurement jig and the test measurement jig, at least three correction data obtaining samples having the same number of ports as the measurement jigs and having different characteristics with each other, and then performing calculations. The present invention can be extended to an arbitrary N-port measurement of 2 or more ports.

The present invention takes not a least amount of leakage signal components that are generated also in the measurement jigs into a correction model, so that correction errors related to the leakage signal components are not generated. Therefore, the correction precision of the relative correction method will be improved, whereby the margin for determining good or bad in the selection step can be reduced, thereby raising the yield ratio. Also, as to components having a high performance, there is no need for ensuring characteristics at a high precision, so that the effect will be further increased.

Moreover, in the case of small-scale components, the terminals and others of the measurement jigs will have a smaller pitch, whereby the leakage signal components will increase; however, in the present invention, the correction can be made at the same precision. In addition, it is possible to meet the scale reduction of components that is considered to proceed further from now on.

Furthermore, the present invention can correct the leakage signal components. Therefore, in the measurement jigs used for mass production, designing and manufacturing can be carried out without worrying about the leakage signal components, so that a low-cost measurement jig having a better contact property and durability than in the past can be realized.

Here, the present invention is not limited to the above-described embodiments and can be carried out by making various changes.

**Claims**

1. A method of correcting measurement errors by calculating, from a result of measuring electric characteristics in a state in which an electronic component having arbitrary n ports of two or more ports is mounted on a test measurement jig, an estimated value of the electric characteristics that would be obtained when measured in a state in which the electronic component is mounted on a standard measurement jig, the method comprising:

a first step of measuring the electric characteristics in a state in which at least three first correction data obtaining samples having different electric characteristics with each other are mounted on the standard measurement jig;
a second step of measuring electric characteristics in a state in which the at least three first correction data obtaining samples, at least three second correction data obtaining samples assumed to have electric characteristics equivalent to those of the at least three first correction data obtaining samples, or at least one third correction data obtaining sample assumed to have electric characteristics equivalent to those of a part of the at least three first correction data obtaining samples and the other ones of the first correction data obtaining samples are mounted on the test measurement jig;
a third step of determining an equation that correlates, on one and the same electronic component, measurement values of electric characteristics measured in a state in which the electronic component is mounted on the test measurement jig with measurement values of electric characteristics measured in a state in which the electronic component is mounted on the standard measurement jig, from a result of measurements in the first and second steps, where the equation assumes presence of leakage signals that are directly transmitted between at least two ports of at least one of the standard measurement jig and the test measurement jig without being transmitted to the electronic component connected to the two ports;

a fourth step of measuring electric characteristics in a state in which an arbitrary electronic component is mounted on the test measurement jig; and

a fifth step of calculating electric characteristics that would be obtained when measured in a state in which the electronic component is mounted on the standard measurement jig, from a result of measurement in the fourth step by using the equation determined in the third step.

2. The method of correcting measurement errors according to claim 1 wherein,

when all the ports at which the leakage signals are present are corrected in each of the base measurement jig and the test measurement jig,

electric characteristics are measured in a state in which at least five of the first correction data obtaining samples having different electric characteristics with each other are mounted on the standard measurement jig in the first step, electric characteristics are measured in a state in which the at least five first correction data obtaining samples, at least five second correction data obtaining samples assumed to have electric characteristics equivalent to those of the at least five first correction data obtaining samples, or at least one of the third correction data obtaining samples assumed to have electric characteristics equivalent to those of a part of the at least five first correction data obtaining samples and the other ones of the first correction data obtaining samples are mounted on the test measurement jig in the second step, and

the equation determined in the third step from the result of measurements in the first and second steps is an equation that assumes correction of the leakage signals of all the ports in each of the standard measurement jig and the test measurement jig.

3. The method of correcting measurement errors according to claim 1 or 2 wherein the equation determined in the third step is,

in a relative error correction circuit network model in which identical ports are connected with each other and different ports assuming presence of leakage signals are connected, between an S parameter at the standard measurement jig and an S parameter at the test measurement jig in measurement of arbitrary n ports,

a T parameter $T_{CA}$' of the relative error correction circuit network model normalized by arbitrary one element in a T parameter $T_{CA}$ of the circuit network model that is calculated by normalizing $T_{CA}$ with the arbitrary one element in $T_{CA}$ on the following equation:

[Equation 1]

$$\begin{bmatrix} \left(S_{T1}{}^{t} \quad I_{n \times n}\right) \otimes \left( -I_{n \times n} \quad S_{D1} \right) \\ \left(S_{T2}{}^{t} \quad I_{n \times n}\right) \otimes \left( -I_{n \times n} \quad S_{D2} \right) \\ \vdots \\ \left(S_{Tm}{}^{t} \quad I_{n \times n}\right) \otimes \left( -I_{n \times n} \quad S_{Dm} \right) \end{bmatrix} \cdot t_{CA} = 0$$

$$t_{CA} = cs\left[T_{CA}\right] = \begin{pmatrix} t_{CA11} \\ t_{CA21} \\ \vdots \end{pmatrix}$$

where $\otimes$ is a Kronecker product, cs[] is a column expansion, the suffix t represents a transpose matrix, and $I_{n \times n}$ is an n $\times$ n unit matrix,

that is represented by using:

an S parameter $S_{Dm}$ of the m-th correction data obtaining sample measurement values in the standard measurement jig,
an S parameter $S_{Tm}$ of the m-th correction data obtaining sample measurement values in the test measurement jig, and
the T parameter $T_{CA}$ of the relative error correction circuit network model.

4. The method of correcting measurement errors according to claim 3 wherein the equation by which the electric characteristics are calculated in the fifth step is,
in a circuit network model in which identical ports are connected with each other and different ports assuming presence of leakage signals are connected, between an S parameter at the standard measurement jig and an S parameter at the test measurement jig in measurement of arbitrary n ports,
$S_D$ calculated based on the following equation:

[Equation 2]

$$S_D = \left( T_{CA11}{}' \cdot S_T + T_{CA12}{}' \right) \cdot \left( T_{CA21}{}' \cdot S_T + T_{CA22}{}' \right)^{-1}$$

that is represented by using:
an S parameter $S_D$ that would be obtained when measured in a state in which the electronic component is mounted on the standard measurement jig,
an S parameter $S_T$ of the electronic component measurement values in the test measurement jig, and
square matrices $T_{CA11}{}'$, $T_{CA12}{}'$, $T_{CA21}{}'$, and $T_{CA22}{}'$ obtained by splitting the T parameter $T_{CA}{}'$ of the relative error correction circuit network model normalized with arbitrary one element in $T_{CA}$ of the relative error correction circuit network model calculated in the third step into $n \times n$.

5. An electronic component characteristics measuring device that calculates, from a result of measuring electric characteristics in a state in which an electronic component having arbitrary n ports of two or more ports is mounted on a test measurement jig, the electric characteristics that would be obtained when measured in a state in which the electronic component is mounted on a standard measurement jig, the device comprising:

equation storing means for storing an equation determined from a first measurement result obtained by measuring electric characteristics in a state in which at least three first correction data obtaining samples having different electric characteristics with each other are mounted on the standard measurement jig and a second measurement result obtained by measuring electric characteristics in a state in which the at least three first correction data obtaining samples, at least three second correction data obtaining samples assumed to have electric characteristics equivalent to those of the at least three first correction data obtaining samples, or at least one third correction data obtaining sample assumed to have electric characteristics equivalent to those of a part of the at least three first correction data obtaining samples and the other ones of the first correction data obtaining samples are mounted on the test measurement jig, where the equation correlates, on one and the same electronic component, measurement values of electric characteristics measured in a state in which the electronic component is mounted on the test measurement jig with measurement values of electric characteristics measured in a state in which the electronic component is mounted on the standard measurement jig, assuming the presence of leakage signals that are directly transmitted between at least two ports of at least one of the standard measurement jig and the test measurement jig without being transmitted to the electronic component connected to the two ports, and
electric characteristics estimating means for calculating, from a result of measuring electric characteristics in a state in which an arbitrary electronic component is mounted on the test measurement jig, the electric characteristics that would be obtained when measured in a state in which the electronic component is mounted on the standard measurement jig, by using the equation stored in the equation storing means.

6. The electronic component characteristics measuring device according to claim 5 wherein,
when all the ports at which the leakage signals are present are corrected in each of the base measurement jig and the test measurement jig,
the equation stored by the equation storing means is determined from:

the first measurement result obtained by measuring electric characteristics in a state in which at least five of the first correction data obtaining samples having different electric characteristics with each other are mounted on the standard measurement jig, and

the second measurement result obtained by measuring electric characteristics in a state in which the at least five first correction data obtaining samples, at least five second correction data obtaining samples assumed to have electric characteristics equivalent to those of the at least five first correction data obtaining samples, or at least one of the third correction data obtaining samples assumed to have electric characteristics equivalent to those of a part of the at least five first correction data obtaining samples and the other ones of the first correction data obtaining samples are mounted on the test measurement jig,

assuming correction of the leakage signals of all the ports in each of the standard measurement jig and the test measurement jig.

7.  The electronic component characteristics measuring device according to claim 5 or 6 wherein the equation stored by the equation storing means is,

in a relative error correction circuit network model in which identical ports are connected with each other and different ports assuming presence of leakage signals are connected, between an S parameter at the standard measurement jig and an S parameter at the test measurement jig in measurement of arbitrary n ports,

a T parameter $T_{CA}'$ of the relative error correction circuit network model normalized by arbitrary one element in a T parameter $T_{CA}$ of the circuit network model that is calculated by normalizing $T_{CA}$ with the arbitrary one element in $T_{CA}$ on the following equation:

$$\begin{bmatrix} \left(S_{T1}{}^t \quad I_{n\times n}\right) \otimes \left( \; - \; I_{n\times n} \quad S_{D1} \; \right) \\ \left(S_{T2}{}^t \quad I_{n\times n}\right) \otimes \left( \; - \; I_{n\times n} \quad S_{D2} \; \right) \\ \vdots \\ \left(S_{Tm}{}^t \quad I_{n\times n}\right) \otimes \left( \; - \; I_{n\times n} \quad S_{Dm} \; \right) \end{bmatrix} \cdot t_{CA} = 0$$

$$t_{CA} = cs\big[T_{CA}\big] = \begin{pmatrix} t_{CA11} \\ t_{CA21} \\ \vdots \end{pmatrix}$$

where $\otimes$ is a Kronecker product, cs[] is a column expansion, the suffix t represents a transpose matrix, and $I_{n\times n}$ is an n × n unit matrix, that is represented by using:

an S parameter $S_{Dm}$ of the m-th correction data obtaining sample measurement values in the standard measurement jig,

an S parameter $S_{Tm}$ of the m-th correction data obtaining sample measurement values in the test measurement jig, and

the T parameter $T_{CA}$ of the relative error correction circuit network model.

8.  The electronic component characteristics measuring device according to claim 7 wherein the equation stored in the equation storing means and used when the electric characteristics estimating means calculates, from a result of measuring electric characteristics in a state in which an arbitrary electronic component is mounted on the test measurement jig, electric characteristics that would be obtained when measured in a state in which the electronic component is mounted on the standard measurement jig is,

in a circuit network model in which identical ports are connected with each other and different ports assuming presence of leakage signals are connected, between an S parameter at the standard measurement jig and an S parameter at the test measurement jig in measurement of arbitrary n ports,

$S_D$ calculated based on the following equation:

[Equation 2]

$$S_D = \left(T_{CA11}' \cdot S_T + T_{CA12}'\right) \cdot \left(T_{CA21}' \cdot S_T + T_{CA22}'\right)^{-1}$$

that is represented by using:
an S parameter $S_D$ that would be obtained when measured in a state in which the electronic component is mounted on the standard measurement jig,
an S parameter $S_T$ of the electronic component measurement values in the test measurement jig, and
square matrices $T_{CA11}'$, $T_{CA12}'$, $T_{CA21}'$, and $T_{CA22}'$ obtained by splitting the T parameter $T_{CA}'$ of the relative error correction circuit network model normalized with arbitrary one element in $T_{CA}$ of the relative error correction circuit network model calculated from the first measurement result and the second measurement result into n × n.

Fig. 1

Fig. 2

Fig. 3

Fig. 4

(a)

(b)

Fig. 5

(a)　No. 1　Port1 | OPEN | OPEN | Port2 ⌐2a

(b)　No. 2　Port1 | SHORT | SHORT | Port2 ⌐2b

(c)　No. 3　Port1 | LOAD | LOAD | Port2 ⌐2c

(d)　No. 4　Port1 | LINE | Port2 ⌐2d

(e)　No. 5　Port1 | -6dBATT | Port2 ⌐2e

Fig. 6a

Fig. 6b

Fig. 7a

Fig. 7b

Fig. 8

Fig. 9

( a )

Signal application

$S_{21\,DUT}$

$(E_{D1})$  $(S_{DUT})$  $(E_{D2})$

$S_{11\,D}$

$S_{11\,DUT}$

$S_{21\,D}$

( b )

Signal application

$S_{21\,DUT}$

$(E_{T1})$  $(S_{DUT})$  $(E_{T2})$

$S_{11\,T}$

$S_{11\,DUT}$

$S_{21\,T}$

( c )

Signal application

80

$S_{21\,DUT}$  $S_{21\,T}$

$(E_{T1})^{-1}$  $(E_{T1})$  $(S_{DUT})$  $(E_{T2})$  $(E_{T2})^{-1}$

$S_{11\,DUT}$

$S_{11\,T}$  $S_{11\,DUT}$

82

$S_{21\,DUT}$

Fig. 10

(a)

Signal application

$S_{11D}$

$(E_{D1})$  $(E_{T1})^{-1}$  $(E_{T1})$  $(S_{DUT})$  $(E_{T2})$  $(E_{T2})^{-1}$  $(E_{D2})$

80

$S_{21DUT}$   $S_{21T}$   $S_{21D}$

$S_{11T}$   $S_{11DUT}$   82

84   86

(b)

Signal application

$S_{11D}$

$C_{10}$   80   $S_{21DUT}$   $S_{21T}$   $C_{32}$   $S_{21D}$

$C_{00}$  $(CA1)$  $(E_{T1})$  $(S_{DUT})$  $(E_{T2})$  $(CA2)$  $C_{33}$

$C_{11}$   $C_{22}$

$C_{01}$   $S_{11T}$   $S_{11DUT}$   82   $C_{23}$

Fig. 11

( a )

( b )

## INTERNATIONAL SEARCH REPORT

| International application No. |
|---|
| PCT/JP2008/072236 |

A. CLASSIFICATION OF SUBJECT MATTER
*G01R27/28*(2006.01)i, *G01R35/00*(2006.01)i

According to International Patent Classification (IPC) or to both national classification and IPC

B. FIELDS SEARCHED

Minimum documentation searched (classification system followed by classification symbols)
G01R27/28, G01R35/00

Documentation searched other than minimum documentation to the extent that such documents are included in the fields searched
Jitsuyo Shinan Koho          1922-1996   Jitsuyo Shinan Toroku Koho   1996-2009
Kokai Jitsuyo Shinan Koho    1971-2009   Toroku Jitsuyo Shinan Koho   1994-2009

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2003-240827 A  (Murata Mfg. Co., Ltd.),<br>27 August, 2003 (27.08.03),<br>Par. Nos. [0066] to [0105]; Fig. 7<br>& US 2003/0120449 A1    & US 2004/0059529 A1<br>& DE 10257434 A          & KR 10-2003-0047846 A<br>& CN 1490629 A | 1,2,5,6<br>3,4,7,8 |
| P,X | JP 2008-64601 A  (Murata Mfg. Co., Ltd.),<br>21 March, 2008 (21.03.08),<br>Full text; all drawings<br>(Family: none) | 1,5 |
| A | JP 2006-242799 A  (Murata Mfg. Co., Ltd.),<br>14 September, 2006 (14.09.06),<br>Par. Nos. [0073] to [0084]; Fig. 1<br>(Family: none) | 1-8 |

☒ Further documents are listed in the continuation of Box C.          ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>27 February, 2009 (27.02.09) | Date of mailing of the international search report<br>10 March, 2009 (10.03.09) |
|---|---|
| Name and mailing address of the ISA/<br>Japanese Patent Office | Authorized officer |
| Facsimile No. | Telephone No. |

Form PCT/ISA/210 (second sheet) (April 2007)

| INTERNATIONAL SEARCH REPORT | International application No. |
| --- | --- |
| | PCT/JP2008/072236 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2006-317448 A  (Agilent Technologies Inc.), 24 November, 2006 (24.11.06), Full text; all drawings & US 7061254 B1        & GB 2426067 A & GB 607384 D0         & DE 102006013458 A | 1-8 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3558074 B

**Non-patent literature cited in the description**

- A METHOD TO CORRECT DIFFERENCE OF IN-FIXTURE MEASUREMENTS AMONG FIXTURES ON RF DEVICES. **GAKU KAMITANI.** APMC. Murata manufacturing Co., Ltd, 2003, vol. 2, 1094-1097

- NEW METHODS FOR CORRELATING FIXTURED MEASUREMENTS. **J.P.DUNSMORE ; L.BETTS.** APMC. Agilent Technologies, 2003, vol. 1, 568-571